# EUROPEAN PATENT APPLICATION

(11) **EP 2 357 313 A2**
(43) Date of publication of application: **17.08.2011**
(21) Application number: 11150492.4
(22) Date of filing: 10.01.2011
(51) Int. Cl.: E21B 33/035

(54) **Electronics module for subsea well installation**

(30) Priority: 01.02.2010 GB 1001543
(71) Applicant: Vetco Gray Controls Limited, Bristol BS48 1BS (GB)
(72) Inventor: Simpson, Steven, Redland, Bristol BS6 6XX (GB); Holley, Stuart, Bedminster, Bristol BS3 3BL (GB)
(74) Representative: Emerson, Peter James

(57) **Abstract**

A subsea electronics module for an underwater well installation comprises a housing and first electronic components located within the housing as a first system to provide functions of a subsea electronics module, wherein second electronic components are located in the housing as a second system diverse from the first system.

## Description

### Field of the Invention

This invention relates to a subsea electronics module for an underwater well installation, an underwater well installation comprising such a module and a method of producing a subsea electronics module for an underwater well installation. In particular the invention is suitable for a subsea hydrocarbon extraction well installation.

### Background of the Invention

Control and monitoring of a subsea well is generally achieved through communication between a surface platform and the well, typically via an umbilical. This terminates at the subsea end at an umbilical termination assembly (UTA), which may house a variety of electronics modules, for example a router module such as a communications electronic module (CEM) mounted within a power and communications distribution module (PCDM), or a subsea electronics module (SEM). Different modules may be associated with different aspects of the well installation, for example a process monitoring (data acquisition) system or a safety and automation (process control) system. Each of these systems may be integrated within separate and independent networks, which may make use of individual communications systems. For the aspects mentioned above for example, signals associated with process monitoring may be sent to the surface via optical lines within the umbilical cable, while safety and automation signals may be transmitted via a communications on power protocol, i.e. superimposed on the power signals transmitted on a copper conductor within the same umbilical.

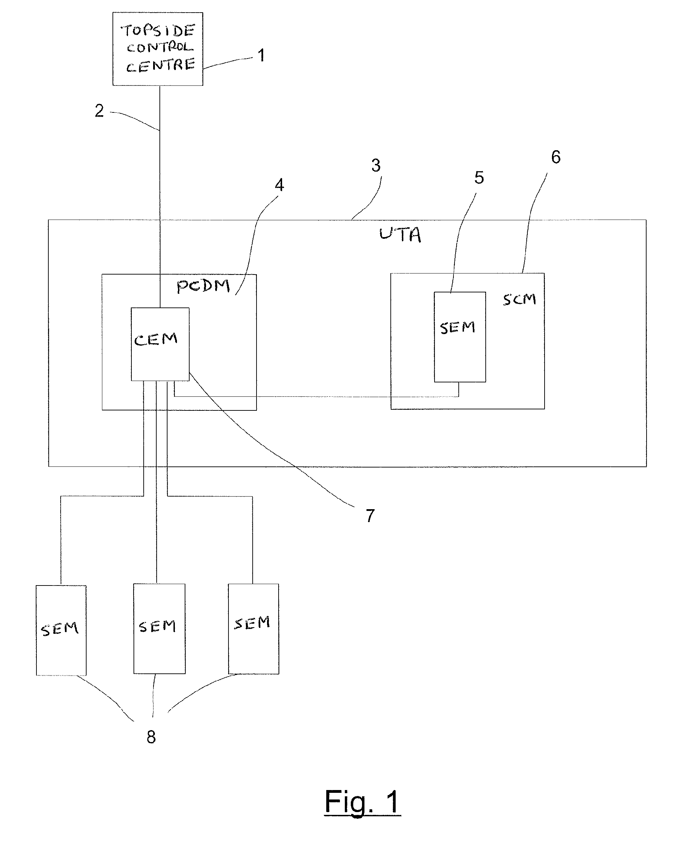

A typical arrangement of an existing well communications system for a multiple well complex is shown in Fig. 1. A topside control centre 1, located for example onshore or at a vessel or rig, communicates via an umbilical cable 2 with a seabed well-field central distribution unit 3. This communication may be for example by optical fibre, or across copper connections, e.g. using a communications on power (COPS) or communications and power (CAPS) system as is known in the art. A further alternative is to use optical fibre for primary communications, with a back-up COPS link. The unit 3 functions as an umbilical termination assembly (UTA) and houses a power and communications distribution module (PCDM) 4 and a subsea electronics module (SEM) 5 housed within a subsea control module (SCM) 6. The SEM 5 is not specific to a well tree, and handles electronic control functions for the multiple well complex. The SCM 6 meanwhile handles hydraulic functions of the well complex, using directional control valves housed within it, which may be opened and closed using electrical signals provided by the SEM 5. Both the terms subsea electronics module, subsea control module and their general functionality are well-known in the art. The PCDM 4 houses a router module such as communications electronic module (CEM) 7 which distributes communications to a multiplicity of additional SEMs 8, each of which is located at a respective one of trees mounted at the heads of individual wells, via copper connections. The CEM 7 and SEM 5 are both housed in containers (not shown) and interfaced with electrical and/or optical fibre connectors capable of withstanding the pressure of the subsea environment, such that rugged encapsulation of each container and protection for the connections is required. Any other electronics modules or packs present would also require such encapsulation and protection. These measures involve substantial costs, and furthermore increase the bulk of the electronics modules.

It is an aim of the present invention to overcome these problems.

### Summary of the Invention

According to the present invention from one aspect, there is provided a subsea electronics module for an underwater well installation, the module comprising a housing and first electronic components located within the housing as a first system to provide functions of a subsea electronics module, wherein second electronic components are located in the housing as a second system diverse from the first system.

According to the present invention from another aspect, there is provided a method of providing a subsea electronics module for an underwater well installation, comprising the steps of:
providing a module including first electronic components located within a housing as a first system to provide functions of a subsea electronics module; and
locating second electronic components in the housing as a second system diverse from the first system.

Said first and second systems could be formed as electronics boards, located within bays in the housing. In this case, said second system could be located in a spare bay in the housing.

Further electronic components could be located in the housing as a further system diverse from the first and second systems.

Said second system could provide functions of a subsea electronics module or could comprise a communications router module.

One of said first and second systems could comprise a process control system adapted for connection to a copper communications network, the other of said first and second systems comprising a process monitoring system adapted for connection to an optical communications network.

Said systems could be encapsulated in the housing.

The present invention also comprises an underwater well installation comprising a module in accordance with the invention.

Such a well installation could comprise a distribution unit located at an underwater location, the distribution unit being adapted for receiving an umbilical cable, the module being housed within the distribution unit. In this case, the distribution unit could house a subsea control module with the subsea electronics module being housed within the subsea control module or the distribution unit could house a power and communications distribution module with the subsea electronics module being housed within the power and communications distribution module.

The term "diverse" as used herein in relation to electronic systems is taken to mean that the respective systems are separate and independent in function and control, such that the operation of one system does not depend or directly impact upon the operation of the other system.

In a preferred embodiment, available space within a modern SEM may be utilised to house the electronics relating to a diverse system, such as the electronics components of a communications router module such as a communications electronic module (CEM) for example. In this way, the costs resulting from the need for a separate housing for the CEM are saved. Furthermore there are options to share power supplies as well, resulting in further savings.

### Brief Description of the Drawings

The invention will now be described with reference to the accompanying drawings, in which:
Fig. 1 schematically shows a known well communications system;
Fig. 2 schematically shows a known well system architecture which may be adapted in accordance with the present invention;
Fig. 3 schematically shows a known well tree SEM which may be adapted in accordance with the present invention;
Figs. 4a and 4b schematically show an electronics module in accordance with an embodiment of the present invention;
Fig. 5 schematically shows a well communications system in accordance with an embodiment of the present invention; and
Fig. 6 schematically shows another well communications system in accordance with an embodiment of the present invention.

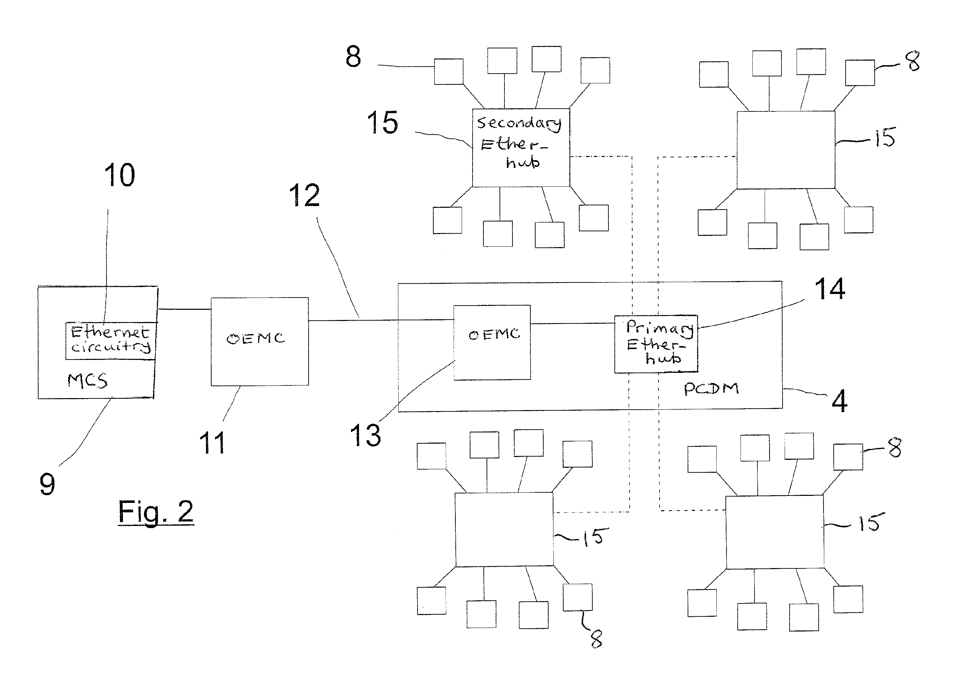

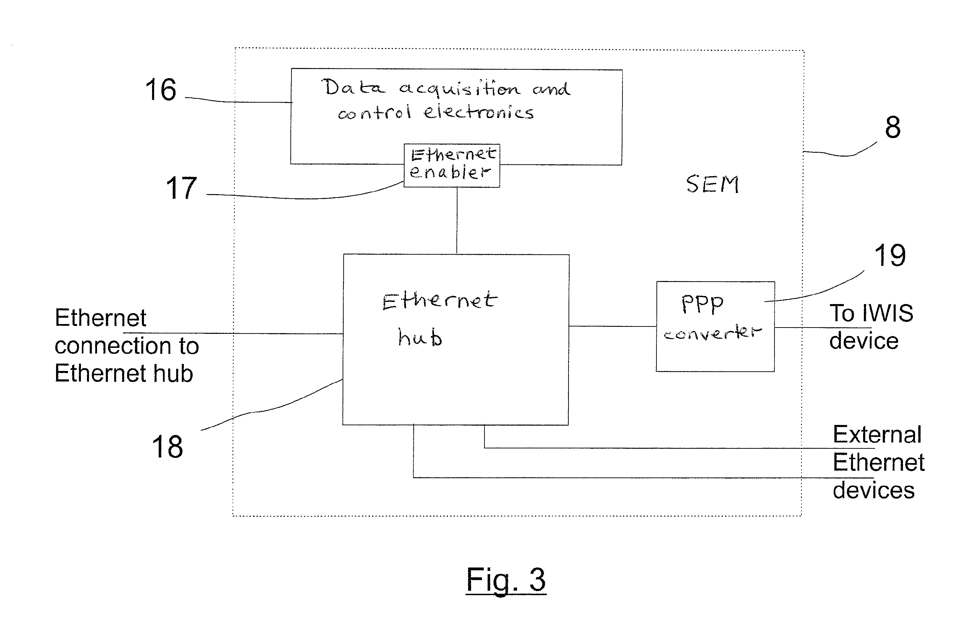

Figs. 2 and 3 show known system architectures, namely as disclosed in GB-A-2443237.

Fig. 2 shows a well system architecture known as a "star" system, which provides a communication link between a shore-based master control station (MCS) 9 and a number of SEMs 8 each located at a respective well tree, via subsea templates. The MCS 9 contains Ethernet circuitry 10 to drive an optical Ethernet media converter (OEMC) 11. This delivers optically modulated digitised data packages to a fibre optic cable 12. Typically this cable 12 is located within an umbilical such as that shown at 2 in Fig. 1, which may be about 600 km long, with the fibre optic cable operating at around 10 mbps. At the other end of the fibre optic cable 12 is a second OEMC 13, which outputs electrical digitised data packages to a primary Ethernet hub 14. Both the OEMC 13 and Ethernet hub 14 are typically housed in a PCDM 4 as also shown in Fig. 1. The primary Ethernet hub 14 outputs to an appropriate required number of secondary Ethernet hubs 15, i.e. templates, in a star configuration. Four of these hubs 15 are shown in Fig. 2 by way of example. Each secondary Ethernet hub 15 feeds an SEM 8 on each of a plurality of well trees.

Fig. 3 schematically shows a LAN configuration set-up of a typical SEM 8. SEM data acquisition and control electronics 16 are provided which interface with an Ethernet enabler 17. An Ethernet hub 18 is provided to link the electronics 16 via enabler 17 both to the template secondary Ethernet hubs 15 (shown in Fig. 2) and an Ethernet to point to point protocol (PPP) converter 19, for example an RS-422 or RS-485 serial interface, to communicate with any devices that utilise an intelligent well interface standard (IWIS). The OEMC 13, primary Ethernet hub 14, and secondary Ethernet hubs 15 would normally have to be housed in a separate router module such as a communications electronic module (CEM), at considerable expense.

In accordance with an embodiment of the present invention however, these components of the communications electronics are instead located within a spare bay of the SEM 5 located in the well field central distribution unit 3. The SEM 5 continues to provide its standard, native, functionality for the production control system.

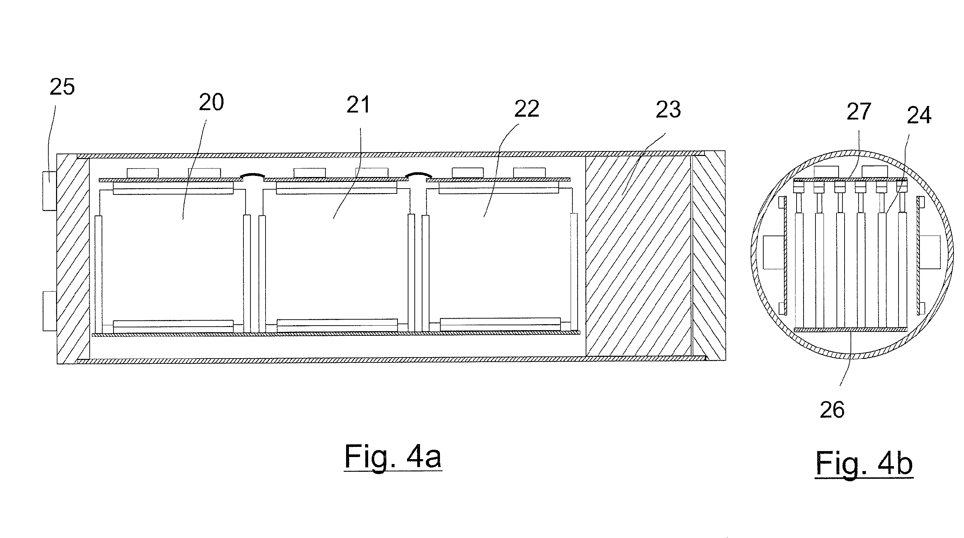

Figs. 4a and 4b illustrate a modern multiple bay SEM, suitable for use with the present invention. The SEM shown has three bays 20, 21 and 22 for holding electronics components. An integral power supply 23 is provided at one end of the SEM. As shown in the sectional view of Fig. 4b, each bay can house a multiplicity of electronics circuit boards 24 which can interface with each other and / or to external connectors 25 via a motherboard 26, or through LAN configuration components 27, similar to those shown in Fig. 3, mounted on top of the cards 24.

Typically only one or two circuit board bays are required to control a well and thus the third bay 22 for example can locate the communications electronics components normally housed within a CEM. Furthermore, the integral power supply of the SEM may power the communication components. Connections to the external connectors 25, to connect the LAN to the SEMs of other wells, can be effected through the motherboard 26. The module may be encapsulated in a similar manner as for standard SEMs.

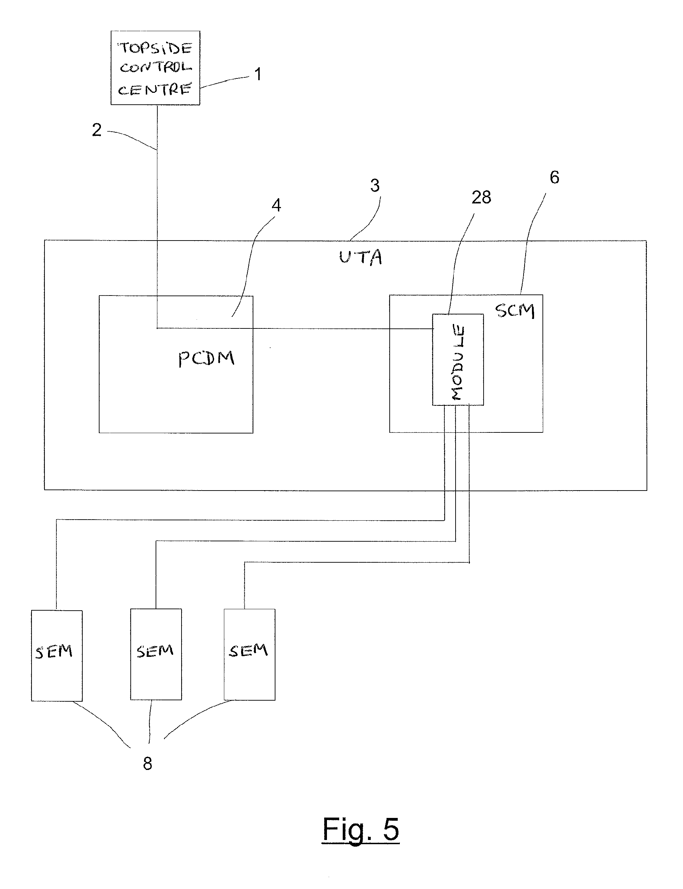

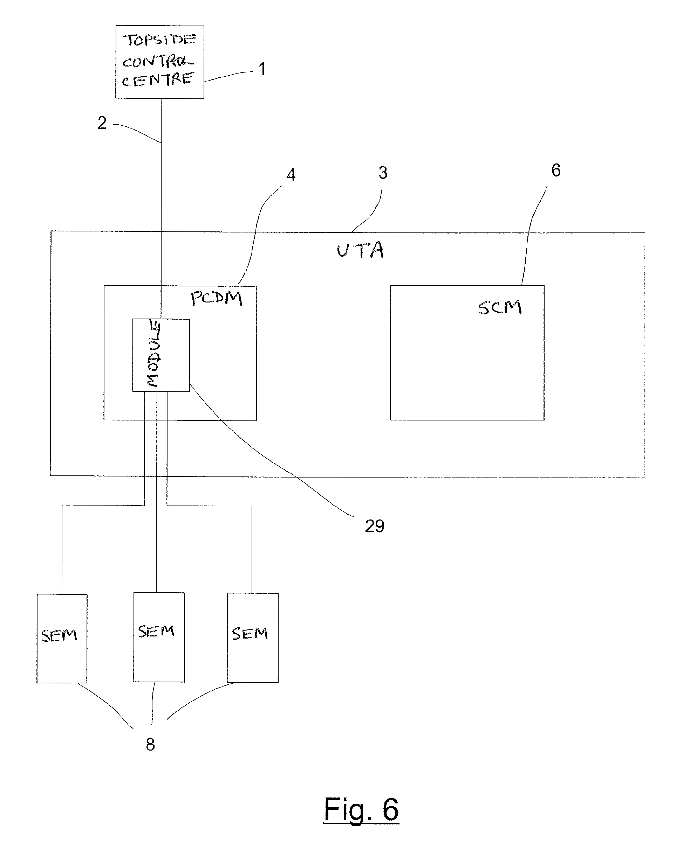

Figs. 5 and 6 show two possible arrangements for locating the combined module. In Fig. 5, a combined module 28 is housed within SCM 6, for example at the same location as for the SEM 5 in Fig. 1. This type of arrangement is most practical for utilisations where the SEM components are used to control SCM functions.

Fig. 6 shows an alternative arrangement, in which a combined module 29 is housed within the PCDM 4, for example at the same location as for the CEM 7 in Fig. 1. This type of arrangement may be practical for utilisations where hydraulic functions of an SCM are not required, for example with "all-electric" systems.

In fact, the location of the module is flexible, and it may be located wherever convenient within the well installation.

The present invention enables components of two diverse systems to be housed within a common module. In the first embodiment described above, these are the production control system controlled by the native SEM components and a communications system controlled by the native CEM components. However, the invention is not limited to this, and other embodiments are possible.

In accordance with an alternative embodiment of the present invention, a common module may be used to house the components relating to two diverse SEMs. In other words, the invention enables a dual SEM architecture with two completely segregated power, communications and related electronics systems, yet with the related components housed within the same module.

In accordance with a further embodiment of the present invention, a common module may be used to house the components relating to both a process control system such as a safety and automation system, and a process monitoring or optimisation system such as a data acquisition system, such systems being diverse. In this example, the process control system components are adapted for connection to a copper communications network, while the process monitoring components are adapted for connection to an optical communications network.

The above-described embodiments are exemplary only, and other possibilities and alternatives within the scope of the invention will be apparent to those skilled in the art. For example, while the above-described embodiments relate to the inclusion of electronics components relating to two diverse systems within a common module, it is possible to house electronics components relating to more than two diverse systems.

## Claims

1. A subsea electronics module for an underwater well installation, the module comprising a housing and first electronic components located within the housing as a first system to provide functions of a subsea electronics module, wherein second electronic components are located in the housing as a second system diverse from the first system.

2. A module according to claim 1, wherein the said first and second systems are formed as electronics boards, located within bays in the housing.

3. A module according to claim 2, wherein said second system is located in a spare bay in the housing.

4. A module according to any preceding claim, wherein said second system provides functions of a subsea electronics module.

5. A module according to any of claims 1 to 4, wherein said second system comprises a communications router module.

6. A module according to any of claims 1 to 4, wherein one of said first and second systems comprises a process control system adapted for connection to a copper communications network and the other of said first and second systems comprises a process monitoring system adapted for connection to an optical communications network.

7. An underwater well installation comprising a module in accordance with any preceding claim.

8. A well installation according to claim 7, comprising a distribution unit located at an underwater location, the distribution unit being adapted for receiving an umbilical cable, wherein the module is housed within the distribution unit.

9. A well installation according to claim 8, wherein the distribution unit houses a subsea control module and the subsea electronics module is housed within the subsea control module.

10. A well installation according to claim 8, wherein the distribution unit houses a power and communications distribution module and the subsea electronics module is housed within the power and communications distribution module.

11. A method of providing a subsea electronics module for an underwater well installation, comprising the steps of:
providing a module including first electronic components located within a housing as a first system to provide functions of a subsea electronics module; and
locating second electronic components in the housing as a second system diverse from the first system.

12. A method according to claim 11, wherein the said first and second systems are formed as electronics boards, located within bays in the housing.

13. A method according to claim 12, wherein said second system is located in a spare bay in the housing.

14. A method according to any of claims 11 to 13, wherein said second system provides functions of a subsea electronics module.

15. A method according to any of claims 11 to 13, wherein said second system comprises a communications router module.

16. A method according to any of claims 11 to 13, wherein one of said first and second systems comprises a process control system adapted for connection to a copper communications network and the other said first and second systems comprises a process monitoring system adapted for connection to an optical communications network.
